# EUROPÄISCHE PATENTANMELDUNG

(11) **EP 3 792 046 A1**
(43) Veröffentlichungstag der Anmeldung: **17.03.2021**
(21) Anmeldenummer: 19196944.3
(22) Anmeldetag: 12.09.2019
(51) Int. Cl.: B29D 11/00, H01L 33/54

(54) **VERFAHREN ZUR HERSTELLUNG ASYMMETRISCHER ODER ASPHÄRISCHER LINSEN SOWIE LEUCHTEINHEIT MIT EINER DERART HERGESTELLTEN LINSE**

(71) Anmelder: Technische Hochschule Wildau, 15745 Wildau (DE)
(72) Erfinder: Dr. Bauer, Joachim, 12524 Berlin (DE); Gutke, Marko, 14167 Berlin (DE); Edling, Matthias, 15370 Petershagen (DE); Prof. Dr. Schrader, Sigurd, 10405 Berlin (DE); Prof. Dr. Gerhard, Christoph, 37136 Ebergötzen (DE)
(74) Vertreter: Heinemeyer, Karsten

(57) **Zusammenfassung**

Beschrieben wird Verfahren zur Herstellung asymmetrischer oder asphärischer Linsen (1) sowie eine Leuchteinheit mit einer derart hergestellten Linse. Bei dem Verfahren wird wenigstens ein polymerhaltiges Medium (3) in einem für einen Durchtritt oder eine Emission von Strahlung vorgesehenen Bereich eines Substrats (2) auf das Substrat (2) unter Bildung eines Formkörpers (4) aufgebracht und das polymerhaltige Medium zumindest zeitweise getrocknet und/oder gehärtet.

Die beschriebene technische Lösung zeichnet sich dadurch aus, dass das Substrat (2) bevor, während und/oder nachdem das noch nicht vollständig getrocknete oder ausgehärtete Medium (3) auf das Substrat (2) aufgebracht wird, derart in eine Formgebungsposition bewegt wird, dass hierdurch wenigstens zeitweise eine Formgebungskraft in das auf das Substrat (2) aufgebrachte Medium (3) eingeleitet wird, deren Wirkrichtung von der Richtung der Erdbeschleunigung abweicht.

## Beschreibung

Die Erfindung betrifft ein Verfahren zur Herstellung asymmetrischer oder asphärischer Linsen sowie eine Leuchteinheit mit einer derart hergestellten Linse. Zur Herstellung einer asymmetrischen oder asphärischen Linse wird ein polymerhaltiges Medium in einem für einen Durchtritt oder eine Emission von Strahlung vorgesehenen Bereich eines Substrats auf das Substrat unter Bildung eines Formkörpers aufgebracht und das polymerhaltige Medium zumindest zeitweise getrocknet und/oder gehärtet.

Allgemein sind aus dem Stand der Technik unterschiedliche Arten von Polymerlinsen bekannt. Die bekannten Polymerlinsen werden entweder nach der Herstellung in hierfür vorgesehene optische Aufbauten integriert oder aber direkt auf Lichtquellen, die sich beispielsweise auf Halbleitersubstraten befinden, angeordnet. In diesem Zusammenhang sind als LED-Chips ausgeführte Lichtquellen bekannt, die mithilfe geeigneter Polymerbeschichtungen vor Umwelteinflüssen geschützt werden und durch Kombination mit Strahlformungsoptiken über die gewünschte Abstrahlcharakteristik verfügen.

Grundsätzlich lassen sich die für optische Zwecke verwendete Linsen in symmetrische und asymmetrische Linsen unterteilen, wobei asymmetrische Linsen über brechende Oberflächen mit nicht rotationssymmetrischen Krümmungsradien verfügen.
Im Weiteren werden Linsen in sphärische und asphärische Linsen eingeteilt, wobei sich asphärische Linsen dadurch auszeichnen, dass diese über wenigstens eine brechende Oberfläche verfügen, deren Form von der Kugelform oder planen Form abweicht, sodass wenigstens eine Oberfläche vorgesehen ist, deren Krümmungsradius nicht konstant ist und üblicherweise von der Mitte zum Rand hin abnimmt. Sphärische und asphärische Linsen können symmetrisch oder asymmetrisch ausgeführt sein.
Mithilfe asphärischer Linsen ist es durch geeignete Ausführung der Linse möglich, die sphärische Aberration, die Grund für die unscharfe Fokussierung symmetrischer Linsen ist, zumindest zu minimieren.

Spezielle asymmetrische Linsen werden oftmals für Leuchteinheiten, wie sie beispielsweise in Straßenlaternen, Fassadenbeleuchtungen, LED-Leuchten und bei Beleuchtungssystemen für Fahrzeuge zum Einsatz kommen, verwendet, um die Abstrahlcharakteristik gezielt zu beeinflussen, insbesondere das ausgesendete Licht in eine bestimmte Richtung zu lenken. Ebenso werden asymmetrische Linsen zur gezielten Lichtverteilung in der Medizintechnik, beispielsweise für UV-LED-Desinfektionsgeräte oder für Lichttherapiesysteme eingesetzt. Regelmäßig ist es hierbei in Abhängigkeit des Einsatzgebietes, so vor allem in der Fahrzeugtechnik, erforderlich, die verwendeten Leuchtmittel auf angemessene Weise und mit geeigneten Materialien zu verkapseln.

Generell ist es bekannt, dass Polymerlinsen, für die zuvor beschriebenen Anwendungen geeignet sind, wobei die Linsen mithilfe von Spritzguss-, Präge- oder 3D-Druckverfahren hergestellt werden.
In diesem Zusammenhang ist beispielsweise aus der US 2013/0056774 A1 ein Verfahren zur Herstellung von asphärischen Polymerlinsen bekannt, die geeignet sind, um auf Halbleiterchips angeordnete LEDs zu verkapseln. Das beschriebene Herstellungsverfahren beruht darauf, dass ein polymerhaltiges Medium im Bereich einer LED auf den Halbleiterchip aufgebracht und der Chip schließlich um 180° gedreht wird, sodass die Erdanziehungskraft auf das Material wirkt und sich nach vollständiger Austrocknung des Materials eine spezielle asphärische Linse ausbildet.

Ferner ist aus der EP 3 460 538 A1 ein Verfahren sowie eine Vorrichtung zur Herstellung von Mikrolinsen bekannt. Das beschriebene Verfahren beruht darauf, dass in einen Bereich eines Halbleitersubstrats, in dem eine Aussparung für eine Linse vorgesehen ist, ein formbares Material aufgebracht wird und durch Prägen mittels eines oberen und eines unteren Linsenstempels eine Linse in das Halbleitersubstrat eingeformt wird. Gemäß der beschriebenen technischen Lösung dient das Halbleitersubstrat selbst als Abstandhalter zwischen dem oberen und dem unteren Linsenstempel, sodass der Prägevorgang auf einen definierten Bereich begrenzt wird.

Im Weiteren ist aus "Umut T. Sanli et. al.; 3D Nanoprinted Plastic Kinoform X-Ray Optics; in: Advanced Materials; 2018, 30, 201802503" ein Herstellungsverfahren bekannt, um Polymerlinsen, die für die Röntgenmikroskopie verwendet werden, mithilfe eines 3D-Druckverfahrens zu erzeugen. Wesentlich bei der beschriebenen technischen Lösung ist, dass als zu druckendes Medium ein Polymer mit besonders günstigen röntgenoptischen Eigenschaften ausgewählt wird und in Abhängigkeit der benötigten optischen Eigenschaften auf der Linsenoberfläche im Wege des 3D-Druckvorgangs spezielle Konturen im Nanometerbereich eingeformt.

Problematisch an den aus dem Stand der Technik bekannten Verfahren zur Herstellung asymmetrischer oder asphärischer Polymerlinsen ist, dass die bekannten Verfahren einen vergleichsweise hohen apparativen Aufwand erfordern oder relativ viel Zeit in Anspruch nehmen. Im Übrigen sind die bekannten Verfahren in der Regel jeweils auf die Herstellung speziell ausgebildeter Linsen ausgelegt, so dass sich die flexible Herstellung unterschiedlicher Linsenformen in kurzer zeitlicher Abfolge oftmals nur verhältnismäßig schwierig realisieren lässt.

Ausgehend von den aus dem Stand der Technik bekannten Verfahren zur Herstellung von asymmetrischen oder asphärischen Polymerlinsen und den zuvor geschilderten Problemen liegt der Erfindung die Aufgabe zu Grunde, ein Herstellungsverfahren anzugeben, das eine flexible und kostengünstige Herstellung unterschiedlich geformter asymmetrischer oder asphärischer Linsen ermöglicht. Gleichzeitig sollte sichergestellt sein, dass mit dem anzugebenden Verfahren sowohl einzelne Linsen als auch Anordnungenmit einer Mehrzahl von Linsen, auf einfache Weise herstellbar sind. Die hergestellten Linsen sollten sich ferner auf besonders vorteilhafte Weise sowohl zur direkten Aufbringung auf Halbleitersubstrate oder Lichtleiter als auch zur Verkapselung von Lichtquellen, insbesondere von auf Halbleitersubstraten angeordneten LEDs, eignen. Ebenso sollten die mit dem anzugebenden Verfahren hergestellten Linsen geeignet sein, um im Rahmen der Chip-on-Board (CoB)-Technologie, bei der LED-Chips direkt auf eine Leiterplatte aufgesetzt und mit Hilfe von Bonddrähten kontaktiert werden, verwendet zu werden, und zwar unabhängig davon, ob die Gehäuse Keramik oder Leiterplattenmaterial aufweisen. Im Weiteren sollten ohne wesentlichen Mehraufwand asymmetrische oder asphärische Linsen herstellbar sein, die sowohl zur gezielten Lichtverteilung als auch zur spezifischen Farbgestaltung des ausgesendeten Lichts genutzt werden können.
Ferner sollten Linsen oder Mikrolinsen herstellbar sein, die in optische Systeme eingebaut oder auf LEDs aufgeklebt werden können. Auch die Herstellung geeigneter Linsenarrays mit transparenten Substraten sollte möglich sein.
Der Erfindung liegt ferner ebenso die Aufgabe zugrunde, eine Leuchteinheit anzugeben, deren Abstrahlcharakteristik auf besonders einfache Weise spezifisch an den jeweiligen Bedarf angepasst werden kann, wobei der Aufwand für die konstruktive Gestaltung der Leuchteinheit und die Anforderungen an die benötigten Komponenten möglichst gering sowie die Anordnung der optischer Bauelemente vergleichsweise einfach sein sollten. Die Herstellung einer entsprechenden Leuchteinheit sollte im Vergleich zu den aus dem Stand der Technik bekannten Lösungen vor allem zeit- und kostensparend sein. Wesentlich ist es im Weiteren, dass die basierend auf der Erfindung hergestellten Linsen sowie Leuchteinheiten, insbesondere für den Einsatz in der Fahrzeugtechnik, in Straßen- und Gebäudebeleuchtungen und auch für den Einsatz in der Medizintechnik und für Flat-Panel-Beleuchtungen geeignet sind.

Die vorstehende Aufgabe wird mit einem Verfahren zur Herstellung asymmetrischer oder asphärischer Linsen gemäß Anspruch 1 gelöst. Eine Leuchteinheit, die die zuvor beschriebene Aufgabe löst, ist im Anspruch 13 angegeben. Vorteilhafte Ausführungsformen der Erfindung sind Gegenstand der abhängigen Ansprüche und werden in der folgenden Beschreibung unter teilweiser Bezugnahme auf die Figuren näher erläutert.

Die Erfindung betrifft zunächst ein Verfahren zur Herstellung asymmetrischer oder asphärischer Linsen, bei dem wenigstens ein polymerhaltiges Medium in einem für einen Durchtritt oder eine Emission von Strahlung vorgesehenen Bereich eines Substrats auf das Substrat unter Bildung eines Formkörpers aufgebracht wird und das polymerhaltige Medium zumindest zeitweise getrocknet und/oder gehärtet wird. Erfindungsgemäß zeichnet sich das Herstellungsverfahren dadurch aus, dass das Substrat bevor, während und/oder nachdem das noch nicht vollständig getrocknete oder ausgehärtete, und damit noch formbare Medium auf das Substrat aufgebracht wird, derart in eine Formgebungsposition bewegt wird, dass hierdurch wenigstens zeitweise eine Formgebungskraft in das auf das Substrat aufgebrachte Medium eingeleitet wird, deren Wirkrichtung von der Richtung der Erdbeschleunigung abweicht. Erfindungswesentlich ist hierbei, dass die gewünschte Formgebung des wenigstens einen, noch nicht vollständig getrockneten oder ausgehärteten polymerhaltigen Mediums erfolgt, indem gezielt eine Kraft in dieses eingeleitet wird, deren Wirkrichtung von der Lotrechten oder Lotrichtung abweicht. Es wird somit gezielt eine Kraft in das polymerhaltige Medium eingeleitet, die eine besonders geeignete und an den jeweiligen Bedarf flexibel anpassbare Formung des polymerhaltigen Materials und somit die Herstellung bedarfsgerecht angepasster asymmetrischer oder asphärischer Linsen ermöglicht. Die Einleitung einer Kraft, deren Wirkrichtung von der Lotrechten oder Lotrichtung, also der örtlichen Richtung der Erd- oder Schwerebeschleunigung, abweicht, hat hierbei den Vorteil, dass gezielt unterschiedliche Linsenformen in Abhängigkeit der gewünschten Eigenschaften einer Linse in Bezug auf eine Lichtverteilung und/oder Farbgebung eingestellt werden können. Generell ist es in diesem Zusammenhang unerheblich, ob eine oder eine Mehrzahl von Linsen gleichzeitig hergestellt wird.

Bei dem erfindungsgemäß vorgesehenen Substrat handelt es sich allgemein um ein Element, das eine für die Aufbringung des polymerhaltigen Mediums geeignete Oberfläche aufweist, wobei die Oberfläche eben sein und/oder eine Struktur und/oder Kontur aufweisen kann. Insbesondere ist es denkbar, dass das Substrat entweder ein Halbleitermaterial aufweist und beispielsweise als Halbleitersubstrat bzw. Halbleiterwafer ausgebildet ist, oder aber als Träger, bevorzugt mit einer geeigneten Oberflächenkontur, ausgeführt und geeignet ist, um optische Bauteile und/oder elektronische Halbleiterbauelemente, wie etwa LEDs, aufzunehmen. Bevorzugt ist ein derartiger Träger derart gestaltet, dass er wenigstens ein Gehäuse bzw. eine Einhausung für ein optisches Bauteil und/oder elektronisches Halbleiterbauelement bereitstellt. Auf besonders vorteilhafte Weise ist es in diesem Zusammenhang denkbar, dass ein derartiges Gehäuse oder Einhausung, in dem ein optisches Bauteil und/oder elektronisches Halbleiterbauelement angeordnet ist, wenigstens bereichsweise, vorzugsweise vollständig, von einer erfindungsgemäß hergestellten Linse überdeckt wird.
In Abhängigkeit der Einsatzzweckes wird das Material, das das Substrat aufweist, gewählt, wobei gemäß einer speziellen Ausgestaltung das Substrat teilweise oder vollständig aus transparentem und/oder transluzentem Material gebildet wird.

Die Einleitung einer entsprechend geeigneten Kraft erfolgt, indem das Substrat bevor, während und/oder nachdem das noch nicht vollständig getrocknete oder ausgehärtete polymerhaltige Medium auf die Substratoberfläche aufgebracht wird auf geeignete Weise bewegt wird. Bei der Bewegung in eine Formgebungsposition kann es sich um eine einmalige Bewegung handeln oder aber es kann eine Mehrzahl von Bewegungen, insbesondere von periodisch wiederkehrenden Bewegungen, zur Formung der gewünschten Linse vorgesehen seien. Die Krafteinleitung erfolgt bevorzugt derart, dass das Substrat, auf dem das Medium bereits angeordnet ist oder auf dem das Medium angeordnet werden soll, in die wenigstens eine Formgebungsposition bewegt wird und das polymerhaltige Material während oder nach dieser Bewegung derart austrocknet oder ausgehärtet, dass eine weitere, ungewünschte Verformung unterbleibt.

In einer besonderen Ausführungsform der Erfindung ist vorgesehen, dass eine Oberfläche des Substrats, auf dem das Medium bereits angeordnet ist oder auf dem das Medium angeordnet werden soll, zumindest zeitweise während oder nach der Aufbringung des Mediums derart relativ zu einer durch das Substrat verlaufenden Lotrechten geneigt wird, dass eine Ebene, in der die Oberfläche des Substrats angeordnet ist, und die Lotrechte einen von 90° abweichenden Kippwinkel einschließen. Die gezielte Einleitung einer Kraft erfolgt gemäß dieser Ausführungsform somit dadurch, dass sich das Substrat mit dem darauf angeordneten noch nicht vollständig ausgehärteten oder getrockneten polymerhaltige Medium in einer gekippten Formgebungsposition befindet, wobei eine asymmetrische oder asphärischen Linse dadurch hergestellt wird, dass eine resultierende Kraft auf das Medium wirkt, die unmittelbar nach Aufbringung des Mediums aus das Substrat eine asymmetrische oder asphärische Verformung des aus dem Medium gebildeten Formkörpers in einer Vorzugsrichtung bewirkt. Vor oder während das auf die Substratoberfläche aufgebrachte Medium aushärtet oder austrocknet wird das Substrat somit gezielt gekippt, so dass der zunächst beispielsweise tropfenartige Formkörper in die gewünschte Linsenform überführt wird. In diesem Zusammenhang ist es generell denkbar, vor, während und/oder nachdem das Substrat gekippt wird, entweder in einem Bereich oder wenigstens zwei Bereichen eines Substrates Medium unter Ausbildung von Formkörpern, insbesondere von tropfenartigen Formkörpern, aufzubringen, sodass zeitgleich wahlweise eine Linse oder eine linien- oder arrayförmige Anordnung von Polymerlinsen erzeugbar ist.
Vorzugsweise wird der Kippwinkel in Abhängigkeit der gewünschten Abstrahlcharakteristik oder Farbgebung gewählt. In diesem Fall kann wiederum berücksichtigt werden, dass entweder nur eine oder eine Mehrzahl von Linsen gleichzeitig durch eine geeignete Kippbewegung erzeugt wird.
Gemäß einer besonderen Ausführungsform der Erfindung ist somit vorgesehen, dass in wenigstens zwei Bereichen des Substrates gleiches Medium oder unterschiedliche Eigenschaften aufweisendes Medium, jeweils unter Ausbildung von Formkörpern auf das Substrat aufgebracht wird und die wenigstens zwei jeweils vom Medium gebildeten Formkörper gemeinsam mit dem Substrat in die Formgebungsposition bewegt werden.

Im Weiteren ist es von Vorteil, wenn in den wenigstens zwei Bereichen des Substrates Medium derart auf das Substrat aufgebracht wird, dass Außenflächen der wenigstens zwei jeweils vom Medium gebildeten Formkörper beabstandet zueinander angeordnet sind. Gemäß dieser speziellen Ausführungsform der Erfindung werden somit wenigstens zwei Linsen auf einem Substrat hergestellt, die sich nicht berühren und dadurch symmetrisch oder asymmetrisch zueinander angeordnet werden können. Auf diese Weise lassen sich wiederum entweder wenigstens zwei unregelmäßig auf einem Substrat verteilte oder eine Mehrzahl von linienförmig oder in Form eines Arrays angeordnete Linsen aus einem polymerhaltigen Material herstellen.

Eine weitere spezielle Ausbildung der Erfindung sieht vor, dass das Substrat mit dem darauf angeordneten, zumindest noch nicht vollständig getrockneten oder ausgehärteten Medium zumindest zeitweise während oder nach der Aufbringung des Mediums in eine Drehbewegung versetzt wird. Generell ist es in diesem Zusammenhang denkbar, dass der Drehpunkt oder die Drehachse durch den wenigstens einen aus polymerhaltigem Medium gebildeten Formkörper verläuft oder aber ein Abstand zwischen dem Schwerpunkt eines Formkörpers aus polymerhaltigem Material und einer Drehachse, um die die Drehbewegung erfolgt, vorgesehen ist. Vorzugsweise wird die Drehgeschwindigkeit der Drehbewegung verändert. So ist es etwa denkbar, dass die Drehgeschwindigkeit in Abhängigkeit des Fortschritts einer Austrocknung oder Aushärtung des polymerhaltigen Materials gezielt verändert wird. Beispielsweise ist es denkbar, zu Beginn des Formgebungsprozesses die Drehgeschwindigkeit gering zu halten und diese in Abhängigkeit des zeitlichen Verlaufs des Aushärtungs- oder Austrocknungsfortschritts des polymerhaltigen Materials zu steigern. Ebenso ist es denkbar, die Lage eines Drehpunkts oder einer Drehachse, um den oder die die Drehbewegung erfolgt, gezielt zu verändern. Entsprechende Veränderungen der Drehgeschwindigkeit oder der Lage eines Drehpunktes oder einer Drehachse erfolgen bevorzugt mithilfe einer Steuereinheit, die entsprechende Veränderungen unter Berücksichtigung des Fortschrittes eines Austrocknungs- oder Aushärtungsprozesses des polymerhaltigen Materials und/oder der herzustellenden Linsenform vornimmt.
Eine entsprechende Steuereinheit ist derart eingerichtet, dass in Abhängigkeit des Aushärtungs- oder Austrocknungsfortschritts und/oder der gewünschten Linsenform geeignete Steuersignale zur Ansteuerung der Bewegung des Substrats mit dem darauf befindlichen Medium in die Formgebungsposition erzeugt werden. Diese Steuersignale können auf der Grundlage von durch einen Nutzer eingegebenen oder in einem Datenspeicher hinterlegten Daten oder mithilfe von Sensoren aufgenommenen Messwerten erzeugt werden. Auf vorteilhafte Weise ist es in diesem Zusammenhang denkbar, dass mithilfe von Sensoren die Bewegung des Substrats mit dem darauf befindlichen Medium, und zwar gleichgültig ob es sich um eine Kipp- oder eine Drehbewegung handelt, erfasst wird, und/oder der Festigkeitsgrad des polymerhaltigen Mediums gemessen wird.

In einer besonders geeigneten Ausführungsform der Erfindung wird das Medium zur Aushärtung und/oder Trocknung vor, während oder nach der Bewegung des Substrats in die Formgebungsposition zumindest zeitweise mit UV-Licht oder sichtbarem Licht bestrahlt wird. In Abhängigkeit des gewählten Mediums kann dessen Bestrahlung auch mit elektromagnetischer Strahlung, die eine oder auch wenigstens zwei gezielt ausgewählte Wellenlängen aufweist, erfolgen. Gemäß einer ganz besonderen Ausführungsform der Erfindung erfolgt die Bestrahlung mit elektromagnetischer Strahlung mit einer Wellenlänge die kleiner als 380 nm ist Hierbei ist es generell denkbar, dass eine entsprechende Bestrahlung nur zeitweise oder in bestimmten Zeitintervallen erfolgt,
Weiterhin ist es auf besonders geeignete Weise denkbar, die Bestrahlung zunächst mit einer ersten, vergleichsweise kurzwelligen Strahlung durchzuführen und anschließend mit einer zweiten Strahlung, deren Wellenlänge größer ist, fortzusetzen. In diesem Fall könnte mit der ersten Strahlung zunächst eine Polymer-Oberflächen-Modifizierung erfolgen, während später das im Inneren befindliche Medium mithilfe der zweiten, langwelligeren Strahlung gehärtet wird. So könnte nach erfolgter Polymer-Oberflächen-Modifizierung das im Inneren befindliche elastische Medium auf geeignete Weise verformt und die gewünschte Linsenform erzeugt werden.

In einer weiteren speziellen Ausgestaltung der Erfindung ist vorgesehen, dass das polymerhaltige Medium vor Einleitung der Bewegung in die Formgebungsposition aus einem festen Zustand in einen fließfähigen Zustand, vorzugsweise durch einen Schmelzvorgang, überführt wird. In diesem Zusammenhang ist es etwa denkbar, dass eine Linse oder ein Linsenarray, die oder das bereits in zumindest weitgehend ausgehärtetem Zustand auf einem Substrat angeordnet ist, zunächst zumindest teilweise aufgeschmolzen und dann in eine Formgebungsposition überführt wird. Insbesondere ist es denkbar, im Wege eines Druckverfahrens oder durch Abformtechnik hergestellte symmetrische Linsen und/oder Linsenarrays mittels Einbringung von thermischer Energie zunächst zu erweichen und anschließend durch Einsatz des erfindungsgemäßen Verfahrens in die gewünschte Form zu bringen.
Im Weiteren ist es denkbar, dass die wenigstens eine aus einem polymerhaltigen Medium gebildete Linse nach Abschluss des Aushärtens und/oder Austrocknens mit wenigstens einem Wiederaufschmelz- und/oder Ätzschritt bearbeitet wird. Mit einem entsprechend ausgewählten geeigneten Bearbeitungsschritt ist es möglich, Oberflächenstrukturen und somit Linsen, die über spezifische Eigenschaften verfügen, herzustellen. Alternativ oder in Ergänzung ist es denkbar, geeignete mechanische oder optische Bearbeitungsverfahren zu verwenden, um auf der Oberfläche der ausgehärteten oder ausgetrockneten Linsen geeignete optische Strukturen, beispielsweise Prismen oder Gitter zu erzeugen.

Ferner kann es von Vorteil sein, wenn der Bereich des Substrats, auf den das Medium aufgebracht wird, vor Aufbringung des Mediums oberflächenbehandelt wird. Eine Oberflächenbehandlung kann wahlweise durch Behandlung bzw. Bearbeitung der Oberfläche und/oder durch Aufbringen eines geeigneten Fluids erfolgen. In diesem Zusammenhang ist es denkbar, dass die Substratoberfläche in dem Bereich, in dem das Medium aufgebracht werden soll, hinsichtlich seiner Hydrophobie gezielt eingestellt wird. Gemäß einer besonderen Weiterbildung wird die Oberfläche des Substrates durch gezielte Einstellung des Grades der Hydrophobie modifiziert, indem zum Beispiel PTFE (Polytetrafluorpolyethylen), HMDS (Hexalmethyldisilizan) und/oder TMSDEA (Trimethylsilyldiethylamine) auf die Oberfläche aufgebracht wird. Alternativ oder ergänzend ist es denkbar, die Substratoberfläche durch unterschiedliche Strukturierung zu modifizieren, um beispielsweise gezielt einen Randwinkel einzustellen, sodass hierdurch die Lichtverteilung der Linse auf ein gewünschtes Maß einstellbar ist.
Durch die Modifizierung der Substratoberfläche mithilfe geeigneter hydrophober Materialien, wie etwa PTFE, oder hydrophiler Materialien, durch eine geeignete Strukturierung der Substratoberfläche, mittels der auch hydrophobe Fläche realisierbar sind, durch Oberflächenmodifizierung mittels Plasmabehandlung und/oder durch geeignete Gestaltung einer LED-Einfassung auf der Substratoberfläche, können somit gezielt Verbesserungen, insbesondere indem die Oberfläche bedarfsgerecht hydrophobiert oder hydrophiliert wird, erzielt werden. In diesem Zusammenhang generiert gemäß einer speziellen Ausführungsform der Erfindung aufgrund der Modifikation der Substratoberfläche das Polymer beim Kontakt mit der Substratoberfläche einen derart großen Abrollwinkel, dass die Einzellinsen in einem Linsenarray separiert werden.

Die Erfindung betrifft im Weiteren eine Leuchteinheit mit einer Lichtquelle, die wenigstens bereichsweise von einer nach dem Verfahren gemäß zumindest einem der zuvor beschriebenen Ausführungsbeispiele hergestellten asymmetrischen oder asphärischen Linse überdeckt ist. Die Leuchteinheit zeichnet sich somit dadurch aus, dass eine speziell hergestellte, asymmetrische oder asphärischen Polymerlinse, die spezielle Eigenschaften in Bezug auf die Lichtformung bzw. Lichtleitung aufweist, verwendet wird, um die Abstrahlcharakteristik der Leuchteinheit gezielt einzustellen. Vorzugsweise verfügt die Lichtquelle über wenigstens eine LED und/oder ein Lichtleiterende, die oder das von einer entsprechend hergestellten asymmetrischen oder asphärischen Polymerlinse zur gezielten Einstellung der Abstrahlcharakteristik überdeckt ist.

Gemäß einer ganz besonderen Ausführungsform sind wenigstens zwei Lichtquellen vorgesehen und derart ausgeführt sowie angeordnet, dass das von den asymmetrischen oder asphärischen Linsen, die den Lichtquellen in Strahlrichtung nachgeschalt sind, ausgesendete Licht gezielt einen bestimmten Raumbereich verstärkt ausleuchtet und/oder in zumindest einem Bereich gemischt wird.
Gemäß der speziellen Ausführungsform zur Mischung von Licht sind die asymmetrischen oder asphärischen Linsen derart hergestellt, dass das die jeweilige Linse verlassende Licht in einen Bereich gelangt, in dem dieses mit dem von einer anderen Linse ausgesandten Licht gemischt wird. Auf diese Weise können mit verhältnismäßig einfachen Mitteln gezielt Lichteffekte, insbesondere unterschiedliche Farbgestaltungen realisiert werden. Die erfindungsgemäß ausgeführte Leuchteinheit bietet somit die Möglichkeit, eine effektive, schräge Lichtverteilung für eine LED oder ein LED-Array zu realisieren, wobei die jeweiligen Polymerlinsen während der Trocknungs- oder Aushärtungsphase bevorzugt schräggestellt oder in eine Drehbewegung versetzt werden.
Ebenso ist es denkbar, mit Hilfe des erfindungsgemäßen Verfahrens Linsen oder Mikrolinsen herzustellen, die in optische Systeme eingebaut oder auf LEDs aufgeklebt werden. In einer weiteren bevorzugten Ausgestaltung ist weiterhin vorgesehen, das transparente Substrate für Linsenarrays erzeugt werden.
Im Übrigen sind mit dem erfindungsgemäßen Verfahren hergestellte Linsen geeignet, um für Chip-on-Board (CoB)-Anwendungen, bei denen LED-Chips direkt auf eine Leiterplatte aufgesetzt und mit Hilfe von Bonddrähten kontaktiert werden, eingesetzt zu werden, und zwar unabhängig davon, ob die Gehäuse Keramik oder Leiterplattenmaterial aufweisen. Im Weiteren können erfindungsgemäß hergestellte Linsen auch unabhängig von der jeweiligen optischen oder lichttechnischen Lösung direkt auf ein Halbleitersubstrat und/oder auf einen Lichtleiter aufgebacht werden. Ferner sind die erfindungsgemäßen Linsen besonders geeignet, um in Sensoren verwendet zu werden.

Gemäß einer weiteren besonderen Ausführungsform der Erfindung verfügt eine Leuchteinheit über eine außermittig in Bezug auf ein Gehäuse, also mit unterschiedlichem Abstand zu einer Rand des Gehäuses, angeordnete Lichtquelle, insbesondere eine LED, die von einer erfindungsgemäß ausgeführten asymmetrischen und/oder asphärischen Linse überdeckt wird. Mit Hilfe einer derart ausgebildeten Leuchteinheit lässt sich eine asymmetrische Lichtlenkung bzw. Ausleuchtung bei gleichzeitig vergleichsweise geringen Effizienzverlusten realisieren. Wesentlich an dieser technischen Lösung ist somit, dass die Lichtquelle innerhalb eines in einem Substrat ausgebildeten Hohlraums, der beispielsweise ein Gehäuse für die LED bildet, außermittig, also mit einem Versatz zum Mittelpunkt angeordnet ist. Gegenüber bekannten Lösungen zur asymmetrischen Ausleuchtung eines Raumbereichs, die über eine außermittig angeordnete Lichtquelle und eine symmetrische Linse verfügen, zeichnet sich die Leuchteinheit gemäß dieser Ausführungsform durch eine vergleichsweise hohe Effizienz aus, da die sonst üblichen Abschattungseffekte verhindert oder zumindest minimiert werden können, insbesondere dann, wenn zusätzlich wenigstens ein Reflektor im Strahlengang vorgesehen ist. Es können auf diese Weise Leuchteinheiten, die sich durch eine vergleichsweise effiziente Weitwinkellichtverteilung auszeichnen, realisiert werden.

Im Folgenden wird die Erfindung ohne Beschränkung des allgemeinen Erfindungsgedankens anhand spezieller Ausführungsformen und unter Bezugnahme auf die Figuren näher erläutert. Dabei zeigen:
- Fig. 1:: Leuchteinheit mit LED und einer asymmetrisch ausgebildeten Mikrolinse zur asymmetrischen Lichtverteilung;
- Fig. 2:: Grafische Darstellung der asymmetrischen Lichtverteilung durch eine auf einer LED angeordnete asymmetrische Mikrolinse;
- Fig. 3:: Herstellung asymmetrischer oder asphärischer Mikrolinsen auf einem Substrat unter Einsatz eines Kippverfahrens;
- Fig. 4:: Herstellung asymmetrischer oder asphärischer Mikrolinsen auf einem Substrat unter Einsatz eines Kippverfahrens während des Dispensprozesses;
- Fig. 5:: Herstellung asymmetrischer Mikrolinsen einem auf Substrat mit LED bei zusätzlichem Einsatz einer Oberflächenmodifizierung;
- Fig. 6:: Herstellung einer Mikrolinse auf einem Substrat mit LED unter Einsatz eines Spinnverfahrens;
- Fig. 7:: Herstellung asymmetrischer Mikrolinsen unterschiedlicher Form auf einem Substrat mit LED unter Einsatz eines Spinnverfahrens;
- Fig. 8:: Vergleich zwischen konventionell und erfindungsgemäß hergestellter Mikrolinse für die gezielte Gestaltung der Lichtverteilung von Leuchteinheiten mit LED;
- Fig. 9:: Lineare und/oder arrayförmige Anordnung einer Mehrzahl von erfindungsgemäß hergestellte Mikrolinsen auf einem Substrat;
- Fig. 10:: Asymmetrisches Mikrolinsenarray für eine homogene Ausleuchtung hergestellt durch Spinnverfahren mit Separation der Linsen durch Oberflächenmodifizierung;
- Fig. 11:: Asymmetrisches Mikrolinsenarray für eine schräge Ausleuchtung hergestellt durch Kippverfahren mit einer Separation durch Mikrostrukturen;
- Fig. 12:: Farbgestaltung mithilfe eines asymmetrischen Mikrolinsenarray unterschiedlich farbiger LEDs sowie
- Fig. 13:: Formung von Polymerlinsen unter Einsatz eines Kippverfahrens.

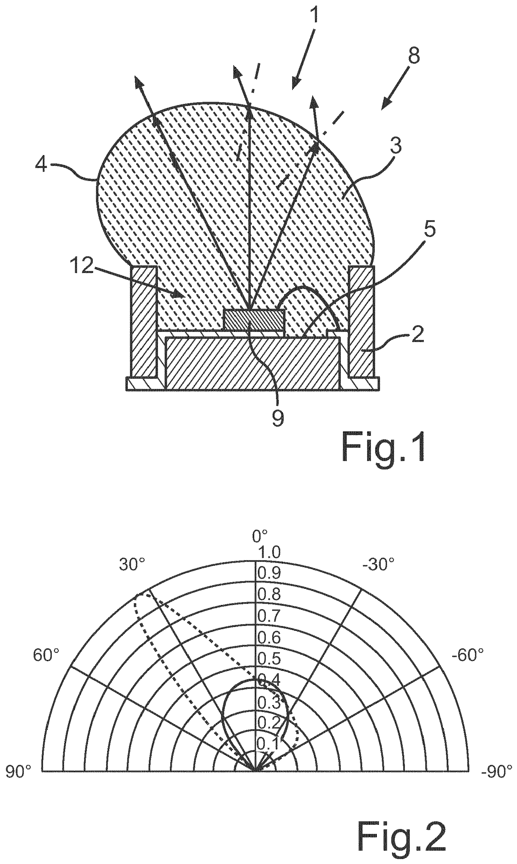

Fig. 1 zeigt zunächst eine Leuchteinheit 8, die über eine auf einem Substrat 2, das allgemein ein Halbleitersubstrat oder einen für die Aufbringung eines ungehäusten Halbleiterchips geeigneten Träger (Chip-on-Board-Technologie (CoB)) aufweisen kann, angeordnete LED als Lichtquelle 9 verfügt. Die Lichtquelle 9 ist von einer asymmetrischen Linse 1, hier in miniaturisierter Form als Mikrolinse ausgeführt, überdeckt. In dem in Fig. 1 gezeigten Ausführungsbeispiel verfügt das Substrat 2 über einen Hohlraum 12, der die Lichtquelle 9 in Form einer ungehäusten LED bzw. eines ungehäuster LED-Chips aufnimmt und der das Gehäuse der Lichtquelle 9 bildet.
Wesentlich für die in Fig. 1 gezeigte Linse 1 ist, dass bei deren Herstellung ein polymerhaltiges Medium 3 in dem Bereich, in dem sich die LED auf dem Substrat 2 befindet, auf die Oberfläche 5 des Substrats 2 aufgebracht wurde, wobei mit dem Medium 3 sowohl der im Substrat 2 gebildete Hohlraum 12 ausgefüllt als auch oberhalb des Substrats 2 ein Formkörper 4 ausgebildet wurde. Generell ist es denkbar, dass die Verfahrensschritte Auffüllen des Hohlraums 12 sowie Ausbilden eines Formkörpers 4 als einstufiger oder zweistufiger Herstellungsprozess, unter Umständen sogar unter Einsatz von Medien 3 mit unterschiedlichen Eigenschaften, ausgeführt werden. Mithilfe eines zweistufigen Herstellungsprozesses könnte eine Linse mit besonders hoher Effizienz hergestellt werden, während ein einstufiger Herstellungsvorgang insbesondere im Hinblick auf die Wirtschaftlichkeit der Linsenherstellung vorteilhaft ist.

Zur Herstellung der gewünschten Linse wurde das Substrat 2 gemeinsam mit der LED und dem darauf angeordneten Medium 3 in eine Formgebungsposition überführt wurde. In dieser Formgebungsposition wurde eine Kraft in das noch nicht ausgehärtete oder ausgetrocknete, somit noch formbare polymerhaltige Medium 3 eingeleitet, deren Wirkrichtung von der Lotrechten, also der Richtung der Erdbeschleunigung, abwich. Während des Aushärtungs- bzw. Austrocknungsprozesses wirkte diese gezielt eingeleitete Kraft auf das noch formbare Polymer ein, sodass sich schließlich nach abgeschlossener Aushärtung bzw. Trocknung die in Fig. 1 dargestellte Linsenform einstellte.

Aufgrund der speziellen Ausgestaltung der Linse 1 emittiert die Leuchteinheit 8 Licht nicht gleichmäßig in alle Raumrichtungen, sondern das Licht wird, wie durch die Pfeile dargestellt, gezielt in hierfür ausgewählte Bereiche abgestrahlt. Die in Fig. 1 dargestellte Leuchteinheit 8 verfügt somit aufgrund des Einsatzes einer speziell hergestellten asymmetrischen Polymerlinse 1 über eine besondere Abstrahlcharakteristik, die sich durch eine asymmetrische Lichtverteilung auszeichnet.

In Fig. 2 ist die Abstrahlcharakteristik der in Fig. 1 gezeigten Leuchteinheit 8 grafisch dargestellt, und es wird deutlich, dass das von der LED emittierte Licht aufgrund der speziellen Linsenform der aus polymerhaltigem Material hergestellten asymmetrischen Linse 1 nur in einen bestimmten Raumbereich abgestrahlt wird.

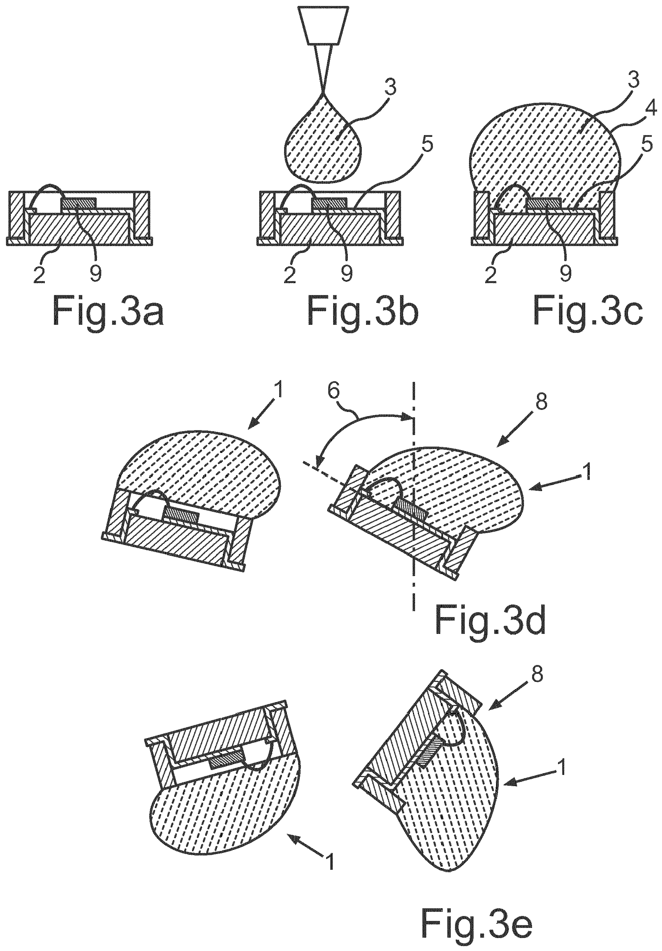

Fig. 3 zeigt den Verfahrensablauf bei der Herstellung einer Leuchteinheit 8 mit LED als Lichtquelle 9, die von einer asymmetrischen und asphärischen miniaturisierten Linse 1 aus einem polymerhaltigen Medium 3 überdeckt wird. In Fig. 3 a) ist der Ausgangszustand gezeigt, nämlich das Substrat 2, das ein Halbleitermaterial aufweist und ein Gehäuse bildet, in dem eine elektrisch leitfähig kontaktierten LED, die die Lichtquelle 9 darstellt, angeordnet ist.
In einem ersten Verfahrensschritt gemäß Fig. 3 b) wird ein polymerhaltiges Medium 3, insbesondere ein optischer Kunststoff, wie beispielsweise Polyurethan (PUR oder PU), Silikon oder Polymethylmethacrylat (PMMA), mithilfe einer Dispensvorrichtung in flüssigem Zustand auf den Bereich des Halbleitersubstrats 2 aufgebracht, in dem sich die LED der Leuchteinheit 8 befindet. Fig. 3 zeigt hierbei eine Ausführungsform des erfindungsgemäßen Verfahrens, bei dem das noch nicht ausgehärtete oder ausgetrocknete, und damit noch formbare Medium 3 aus polymerhaltigem Material unter Ausbildung eines Formkörpers 4 auf das Substrat 2 aufgebracht wird, während sich das Substrat 2 noch in der Ausgangsposition befindet. Nach Aufbringen des polymerhaltigen Mediums 3 bildet dieses den in Fig. 3 c) gezeigten, noch vergleichsweise einfach formbaren Formkörper 4 aus.

In den in Fig. 3 d) und e) gezeigten Verfahrensschritten wird das Substrat 2 gemeinsam mit dem darauf aufgebrachten Medium 3 aus polymerhaltigem Material in eine Formgebungsposition bewegt, wobei in diesem Fall Kippbewegung ausgeführt wird. In Abhängigkeit des gewählten Kippwinkels 6, also dem Winkel, der sich zwischen der Ebene, in der sich die Substratoberfläche, auf der das polymerhaltige Medium 3 angeordnet ist, befindet und einer durch die Substratoberfläche 5 verlaufenden Lotrechten, also einer in Richtung der Erdbeschleunigung verlaufenden Geraden einstellt, können unterschiedliche Linsenformen hergestellt werden. Wird das Substrat 2, das hier wiederum als Träger mit einem Gehäuse für die Lichtquelle 9 ausgeführt ist, gemeinsam mit dem darauf aufgebrachten Polymermedium 3 in die in Fig. 3 d) gezeigten Positionen überführt, so werden asymmetrische miniaturisierte Linsen 1 durch Kippung hergestellt.
Wird ein noch größerer Kippwinkel 6 zur Herstellung einer speziell geformten Polymerlinse 1 gewählt, so können die in Fig. 3 e) gezeigten Linsenformen, die asphärisch bzw. elliptisch sind, in Abhängigkeit der Oberflächenspannung des polymerhaltigen Mediums 3 und des Substrates 3 erzeugt werden. Hierbei wird auf vorteilhafte Weise berücksichtigt, dass die zuvor genannten Parameter die Bewegung und Formgebung des polymerhaltigen Mediums beeinflussen, da es in Abhängigkeit des eingestellten Kippwinkels, der Oberflächenspannung des polymerhaltigen Mediums 3 und/oder der Eigenschaft des Substrates zu einem Wegrollen und/oder Abtropfen des Mediums 3 kommen kann.

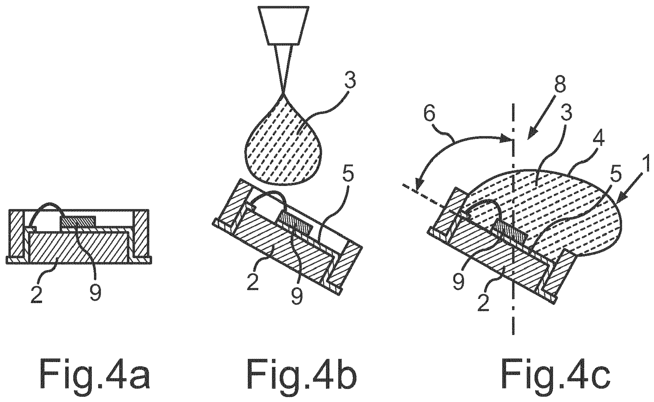

Fig. 4 zeigt abermals die Herstellung einer asymmetrischen miniaturisierten Linse 1 auf einem Substrat 2 aus Halbleitermaterial mit einer LED bei Einsatz eines Kippverfahrens, wobei das Kippen gemäß der in Fig. 4 gezeigten Ausführungsform bereits während des Dispensvorganges, also während des Aufbringen des polymerhaltigen, noch nicht ausgehärteten oder ausgetrockneten, und somit formbaren Mediums 3 auf die Substratoberfläche 5 erfolgt. Fig. 4 b) ist in diesem Zusammenhang zu entnehmen, dass das Substrat 2 mit der LED bereits gekippt ist, bevor das polymerhaltige Medium 3 zur Ausbildung eines Formkörpers 4 die Oberfläche 5 des Substrats 2 berührt. Ergänzend zeigt Fig. 4 c) den Zustand der Leuchteinheit 8, in dem sich diese befindet, nachdem das polymerhaltige Medium 3 auf die gekippte Substratoberfläche 5 aufgebracht wurde. Mithilfe des in Fig. 4 dargestellten Herstellungsverfahren lässt sich wiederum eine asymmetrische Mikrolinse 1 auf einem Substrat 2 mit einer LED als Lichtquelle 9, das entweder ein Halbleitersubstrat 2 oder, wie hier gezeigt, einen Träger mit einem Gehäuse (CoB-Technologie) aufweist, herstellen.

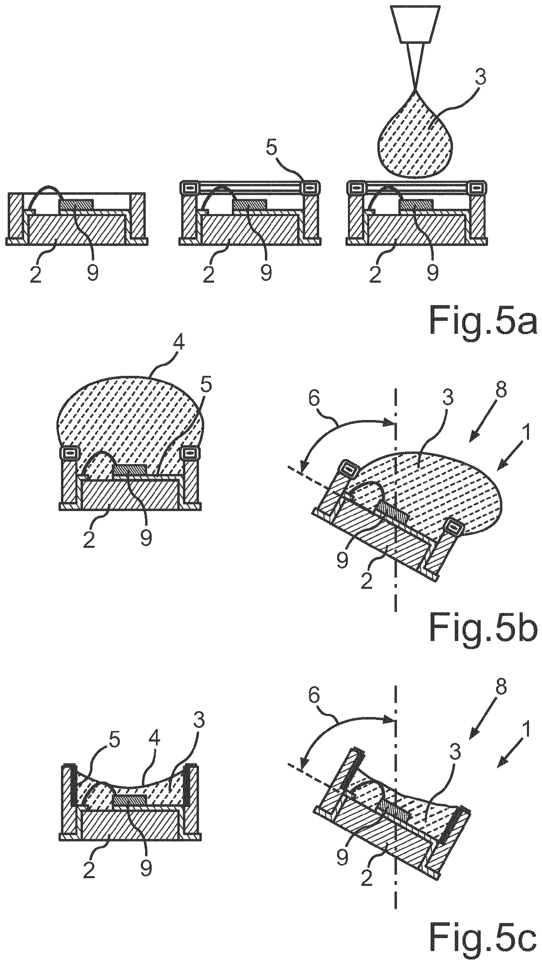

In Fig. 5 ist ergänzend die Herstellung einer asymmetrischen Linse 1 auf einem Substrat 2 mit LED als Lichtquelle 9 dargestellt, wobei die Oberfläche 5 des Substrats 2 oder das Substrat 2 vor Aufbringung des polymerhaltigen Mediums 3 zusätzlich auf geeignete Weise modifiziert wird. Gemäß dem in Fig. 5 gezeigten Ausführungsbeispiel wird die Oberfläche 5 des Substrats 2 vor Aufbringung des polymerhaltigen Mediums 3 hydrophobiert oder hydrophiliert, sodass sich eine modifizierte Substratoberfläche 5 einstellt. Die Modifizierung der Substratoberfläche 5 wird hierbei derart durchgeführt, dass sich ein gezielt ausgewählter Kontaktwinkel einstellt und ein Überschreiten des Abrollwinkels des Polymers verhindert wird.
Durch Aufbringen des polymerhaltigen Mediums 3 auf einen Bereich, in dem die Substratoberfläche 5 modifiziert ist, kann auf der Substratoberfläche 5 ein Formkörper 4 ausgebildet werden, der über ganz spezielle Eigenschaften verfügt, insbesondere nicht auf der Oberfläche 5 des Substrats 2 verläuft oder eine Kugelform annimmt und sich trotzdem mit der Oberfläche vollflächig verbindet.

Fig. 5b) zeigt wiederum den Verfahrensschritt, in dem das Substrat 2 mit der LED und dem auf der hydrophoben Substratoberfläche 5 angeordneten Formkörper 4 aus polymerhaltigem Medium 3 um einen geeigneten Kippwinkel 6 zur Erzeugung einer asymmetrischen miniaturisierten Linse 1 gekippt wird.
Im Vergleich hierzu zeigt Fig. 5 c) den Verfahrensschritts des gemeinsamen Kippens von Substrat 2 und Medium 3, bei einer Substratoberfläche 5, die vor dem Aufbringen des Mediums 3 hydrophiliert wurde.

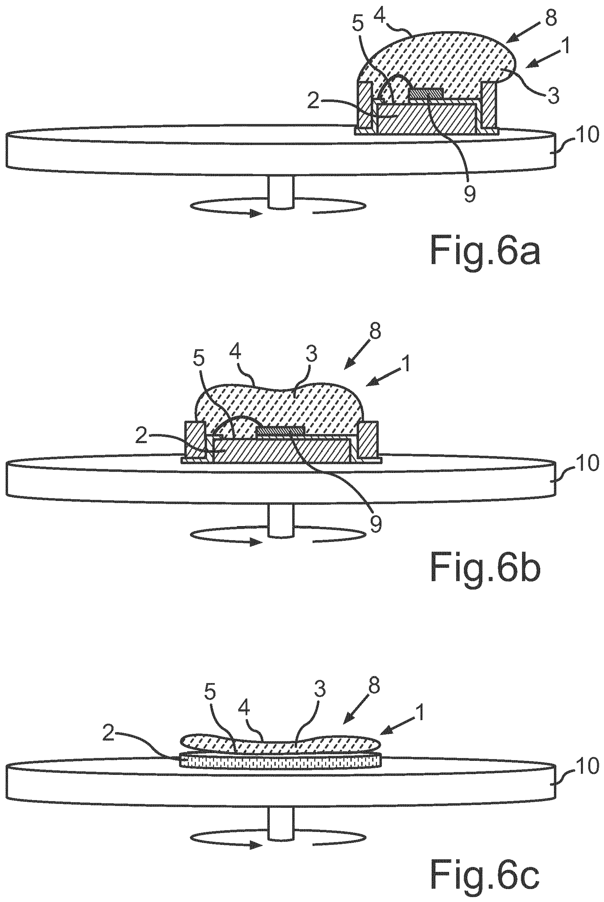

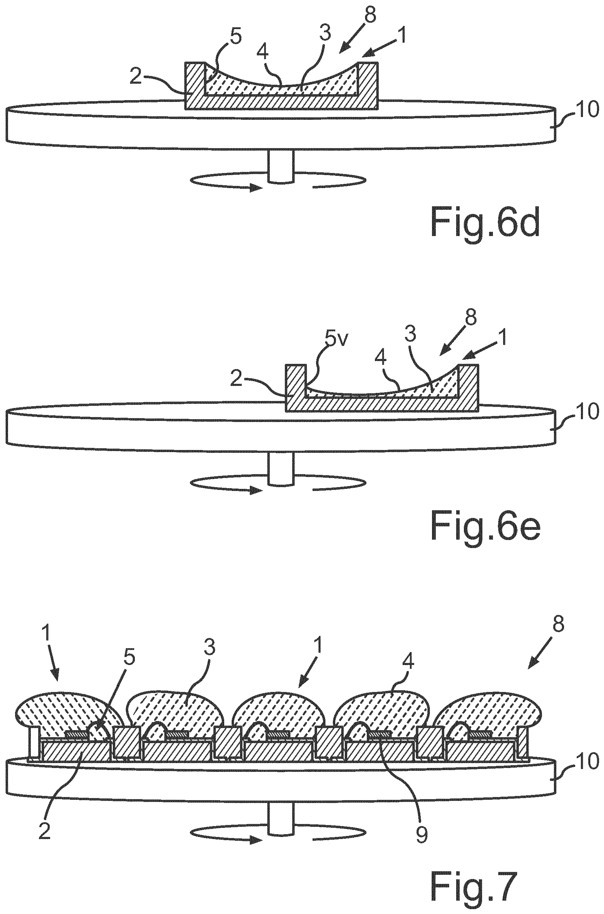

In Fig. 6 ist eine alternative Ausführungsform der Erfindung dargestellt, bei der ein noch nicht vollständig getrocknetes oder ausgehärtetes Medium 3 unter Ausbildung eines Formkörpers 4 auf ein Substrat 2 mit darauf als Lichtquelle 9 angeordneter LED aufgebracht wird und mithilfe eines Spinverfahrens, bei dem das Substrat 2 mit dem darauf angeordneten polymerhaltigen Medium 3 in eine Drehbewegung versetzt wird, eine asymmetrische oder asphärische Linse hergestellt wird. Wesentlich an der in Fig. 6 gezeigten speziellen Ausführungsform des erfindungsgemäßen Verfahrens ist, dass das Substrat 2 mit dem darauf angeordneten polymerhaltigen Medium 3 nach dessen Aufbringung in eine Drehbewegung um eine Rotationsachse versetzt wird.
In diesem Zusammenhang zeigt Fig. 6 a) eine spezielle Ausführungsform, bei der das Substrat 2 mit dem darauf angeordneten Medium 3 derart auf einer Drehscheibe 10 angeordnet ist, dass zwischen der Drehachse, um die die Drehbewegung erfolgt, und dem Substrat 2 mit dem darauf angeordneten Formkörper 4 aus polymerhaltigem Medium 3 ein Abstand vorhanden ist. Aufgrund der Drehbewegung und der hierdurch auf das noch nicht vollständig getrocknete oder ausgehärtete polymerhaltige Medium 3 wirkenden Zentrifugalkraft bewegt bzw. verformt sich das auf dem Substrat 2 angeordnete polymerhaltige Medium 3 zumindest teilweise nach außen. Daher bildet sich die in Fig. 6 a) gezeigte Linsenform auf dem Substrat 2 aus.

Im Vergleich zu der in Figur 6 a) gezeigten Ausführungsform wird das Substrat 2 mit dem darauf angeordneten polymerhaltigen Medium 3 gemäß dem in Fig. 6 b) dargestellten Ausführungsbeispiel zentrisch zur Rotationsachse angeordnet, sodass die Rotationsachse senkrecht zur Substratoberfläche 5 und durch den Schwerpunkt des aus polymerhaltigem Medium 3 gebildeten Formkörpers 4 verläuft. Die Drehbewegung bewirkt auch in diesem Fall die gewünschte Verformung des noch nicht vollständig ausgehärteten oder ausgetrockneten polymerhaltige Mediums 3, wobei sich allerdings, wie in Fig. 6 c) deutlich zu sehen, eine asphärisch konvexe Linse 1 ausbildet, wobei ein Substrat 2, das wenigstens bereichsweise ein transparentes Material aufweist, verwendet wird. Ergänzend zeigen die Fig. 6 d) und e) den Einsatz des Spinverfahrens zur Ausbildung asphärischer oder sphärischer und asymmetrisch konkaver Linsen 1. Um entsprechende Linsenformen erzeugen zu können, wird die Substratoberfläche 5 vor Aufbringung des Mediums 3 derart modifiziert, dass die Substratoberfläche 5 wenigstens bereichsweise hydrophil wird.

Fig. 7 zeigt wiederum ein Ausführungsbeispiel, bei dem das bereits zuvor erläutertes Spinverfahren zur Herstellung von miniaturisierten Linsen 1, auch Mikrolinsen genannt, zum Einsatz kommt. Gemäß dem in Fig. 7 gezeigten Ausführungsbeispiel werden gleichzeitig eine Mehrzahl von Linsen aus noch nicht ausgehärtetem oder ausgetrocknetem polymerhaltigem Medium 3 auf der Oberfläche 5 eines Substrats 2 ausgebildet, die während der Formgebungsphase um eine Drehachse gedreht werden. Aufgrund des unterschiedlichen Abstandes der einzelnen auf einem Halbleitersubstrat 2 ausgebildeten Formkörper zur Drehachse wirken auf diese unterschiedlich großen Zentrifugalkräfte. Aus diesem Grund wird in der Mitte wiederum eine asphärisch Linse ausgebildet, während die äußeren Linsen 1 asymmetrisch ausgeformt werden. Der Grad der Asymmetrie der einzelnen Linsen 1 variiert hierbei mit der Größe des Abstandes von der Drehachse. Mithilfe des erfindungsgemäßen Verfahrens zur Herstellung asymmetrischer oder asphärischer Linsen 1 kann somit, wie in Fig. 7 gezeigt, auf vergleichsweise einfache Weise eine geeignet ausgebildete Anordnung von Linsen 1 und oder Leuchteinheiten 8 mit entsprechenden Linsen 1 hergestellt werden.

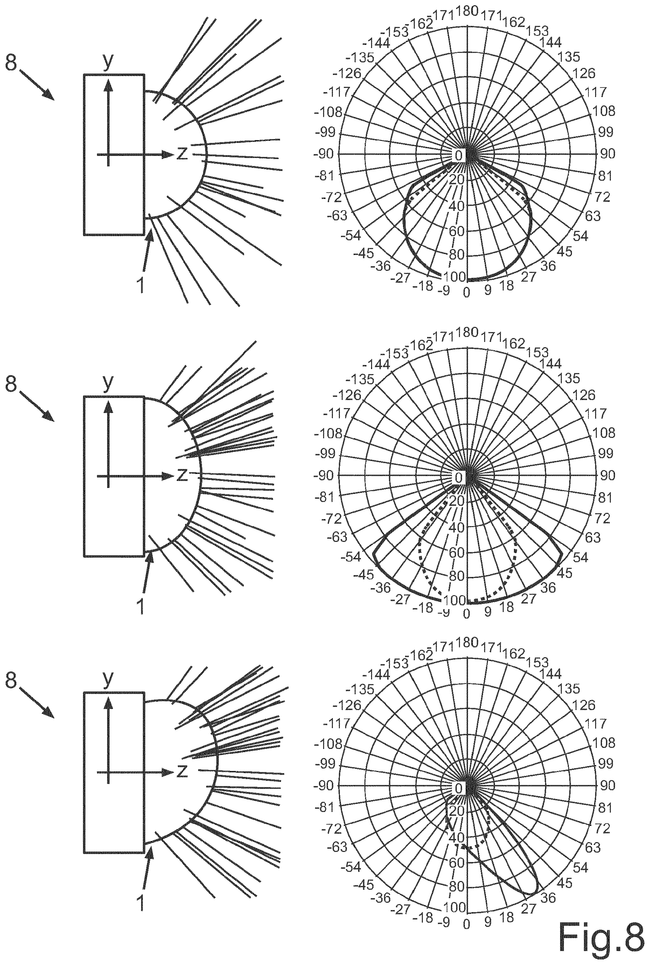

Fig. 8 zeigt in den Ansichten a), b) und c) jeweils mithilfe des erfindungsgemäßen Verfahrens hergestellte Leuchteinheiten 8 mit LEDs als Lichtquellen 9, die in einem im Substrat 2 ausgebildeten rechteckigen Gehäuse angeordnet sind und die über erfindungsgemäß hergestellte miniaturisierte Linsen 1 verfügen. Neben den Leuchteinheiten 9 ist jeweils grafisch die Abstrahlcharakteristik der entsprechend ausgeführten Leuchteinheiten 9 dargestellt. Fig. 8 veranschaulicht hierbei, wie mithilfe des erfindungsgemäßen Verfahrens auf vergleichsweise einfache Weise gezielt Leuchteinheiten 9 mit miniaturisierten Linsen aus polymerhaltigem Medium 3, die über spezielle Abstrahlcharakteristika verfügen, hergestellt werden können.

In Fig. 8 a) ist in diesem Zusammenhang eine sphärische Linse zum Vergleich dargestellt. Fig. 8 b) zeigt eine asphärische Linse und Fig. 8 c) eine asymmetrische Linse, wie sie bevorzugt für eine schräge Ausleuchtung verwendbar ist.

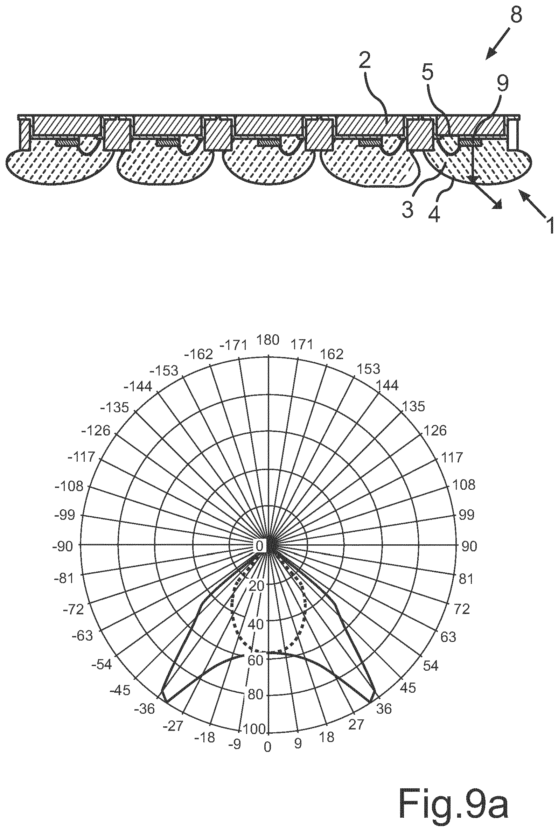

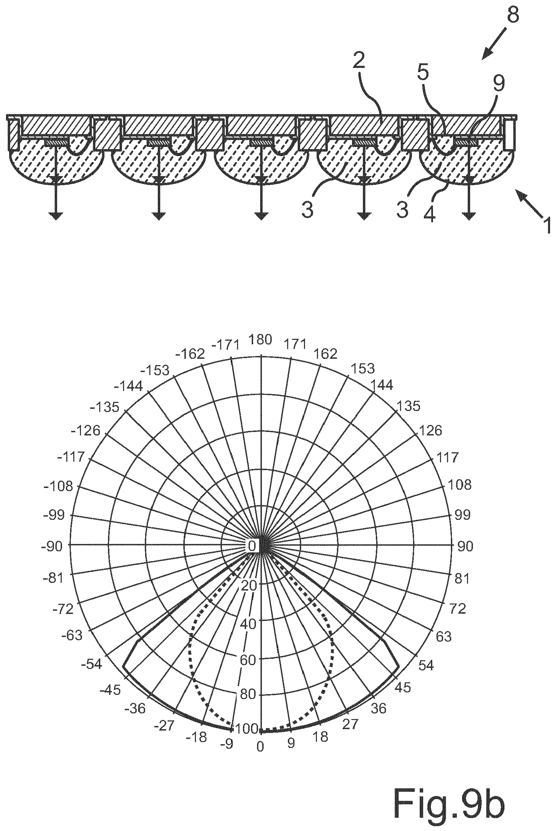

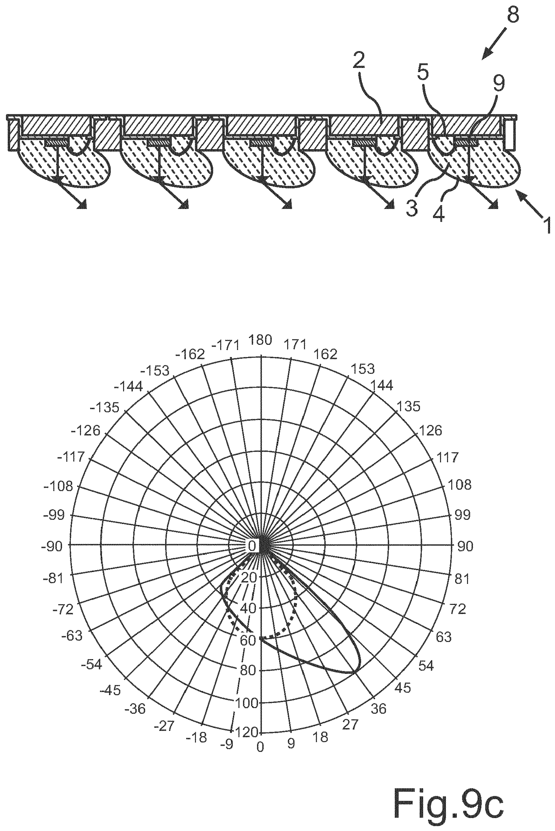

Im Weiteren zeigt Fig. 9 in den Ansichten a), b) und c) unterschiedliche lineare Mikrolinsensysteme, wie sie mit den zuvor erläuterten Verfahren hergestellt werden können. Die in Fig. 9 a) dargestellte Anordnung von Linsen 1 kann auf bevorzugte Weise mit einem Verfahren, wie es im Zusammenhang mit der Fig. 7 erläutert wurde, hergestellt werden. Die grafische Darstellung der Abstrahlcharakteristik verdeutlicht wiederum, dass mit der gezeigten linearen oder zeilenförmigen Linsenanordnung ganz gezielt ausgewählte Bereiche besonders ausgeleuchtet werden. Dies wird erreicht, indem mittig wiederum eine asphärisch symmetrische Linse 1 angeordnet ist, während beidseitig dieser asphärisch symmetrischen Linse 1 wiederum asymmetrische Linsen oder asymmetrisch und asphärische Linsen, die unterschiedliche Asymmetrien aufweisen, angeordnet sind.

Die Anordnung von miniaturisierten Linsen, wie sie in Figur 9 b) gezeigt ist, kann beispielsweise hergestellt werden, indem die einzelnen Leuchteinheiten 9 mithilfe des Spinnverfahrens hergestellt und dann zusammengefügt werden. Die Anordnung verfügt ausnahmslos über asphärisch symmetrische Linsen 1.
Sämtliche in Figur 9 b) gezeigten Leuchteinheiten 9 mit LED als Lichtquelle 8 verfügen somit über die gleich Abstrahlcharakteristik, sodass sich insgesamt die wiederum grafisch dargestellte Gesamtabstrahlcharakteristik ausbildet. Hierbei wird deutlich, dass ein vergleichsweiser großer Bereich vorhanden ist, in dem eine sehr gleichmäßige, intensive Strahlung, aufgrund der Überbeschneidung der einzelnen Strahlen, in den Raum abgestrahlt wird. Diese Anordnung ist geeignet eine besonders gleichmäßige Ausleuchtung eines Raumbereichs zu erreichen.

Figur 9 c) zeigt eine Anordnung miniaturisierter Linsen 1, wobei die einzeln, linear oder zeilenförmig angeordneten Linsen 1 bevorzugt mithilfe des Kippverfahrens hergestellt worden sind. Die einzelnen Mikrolinsen 1 sind baugleich ausgeführt, wobei es sich jeweils um asymmetrische Linsen mit der gleichen Asymmetrie handelt. Die einzelnen Mikrolinsen 1 und damit auch das aus diesen gebildete Mikrolinsenarray leuchten schräg in einen seitlichen Raumbereich.
Dieses verdeutlicht wiederum die grafische Darstellung der Abstrahlcharakteristik der Linsenanordnung. Mit der Anordnung von Linsen gemäß Fig. 9 c) lässt sich eine schräge Ausleuchtung realisieren.

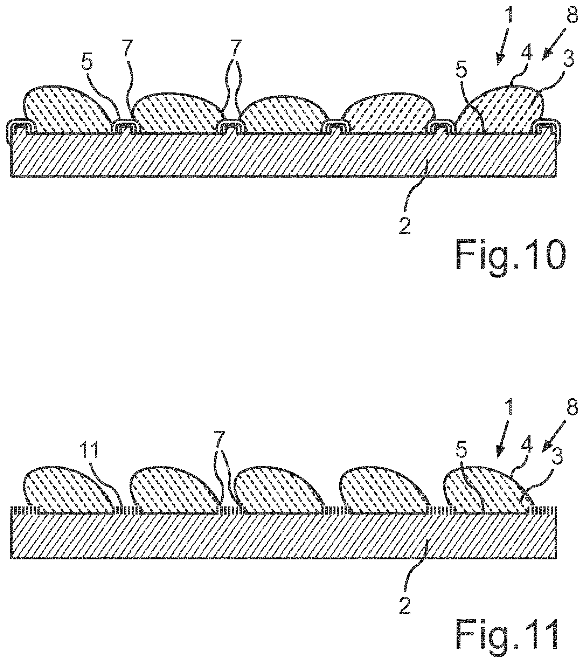

Im Weiteren zeigt Fig. 10 nochmals ein asymmetrisches Mikrolinsenarray für eine homogene Ausleuchtung, wie es beispielsweise durch das Spinnverfahren gemäß Fig. 7 hergestellt wurde. Die Separation der einzelnen Mikrolinsen 1 wird durch eine geeignete Oberflächenmodifizierung des Substrates 2, sicherstellt, sodass die Außenflächen 7 der einzelnen, aus polymerhaltigem Medium 3 gebildeten Formkörper 4 beabstandet zueinander auf der Oberfläche 5 des in diesem Fall transparenten Substrats 2 angeordnet sind.

In Fig. 11 ist ein asymmetrisches Mikrolinsensystem für eine schräge Ausleuchtung dargestellt. Das gezeigte asymmetrische Mikrolinsenray wird bevorzugt durch ein Kippverfahren hergestellt. In diesem Fall erfolgt die Separation der einzelnen Mikrolinsen 1 nicht, wie in Fig. 10 gezeigt, durch eine Oberflächenmodifizierung, sondern es werden gezielt geeignete Mikrostrukturen 11 in einem Substrat 2, hier einem transparenten Material, wie etwa Glas, entweder durch ein additives Verfahren oder durch Ätzen hergestellt.

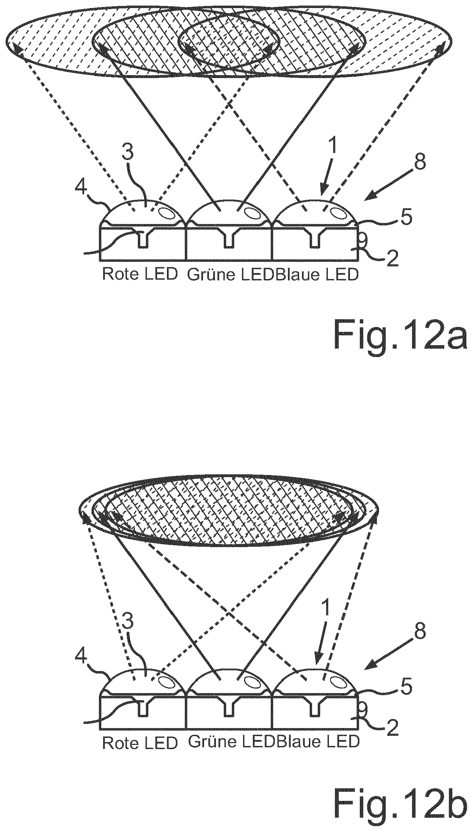

Fig. 12 zeigt in den Ansichten a) und b) jeweils eine Anordnung von drei Leuchteinheiten 8, die über eine LED als Lichtquelle 9 und eine oberhalb der LED angeordnete, mit dem erfindungsgemäßen Verfahren hergestellte Linse 1 verfügen. Die drei LEDs emittieren Licht unterschiedlicher Farbe, nämlich rotes, grünes oder blaues Licht.
Gemäß dem in Fig. 12 a) gezeigten Ausführungsbeispiel sind die Mikrolinsen als asphärisch symmetrische Linsen ausgeführt. Das von den LEDs emittierte Licht wird von den einzelnen im Strahlengang den LEDs nachgeordneten Linsen 1 aus polymerhaltigem Medium 3 derart gelenkt, dass einzelne Bereiche geschaffen werden, in denen Licht unterschiedlicher Farbe gemischt wird. So entstehen etwa Außenbereiche, in die lediglich rotes und blaues Licht abgestrahlt wird, während im Inneren Bereiche geschaffen werden, in denen grünes, blaues und rotes Licht in unterschiedlichen Intensitäten gemischt wird. Die gezeigte technische Lösung zeigt eine Weißlichtausleuchtung mit störenden Farbrändern.

Fig. 12 b) zeigt wiederum eine Anordnung von Leuchteinheiten 8, von denen die beiden äußeren über asymmetrische und asphärische Linsen verfügen, wären die mittige Leuchteinheit 9 über eine sphärisch symmetrische Linse 1 verfügt. Auch bei dem in Fig. 12 b) gezeigten Ausführungsbeispiel entstehen wiederum Bereiche, in denen Licht unterschiedlicher Farbe gemischt wird. Die gezeigte technische Lösung kann für eine homogene Weißlichtausleuchtung verwendet werden.

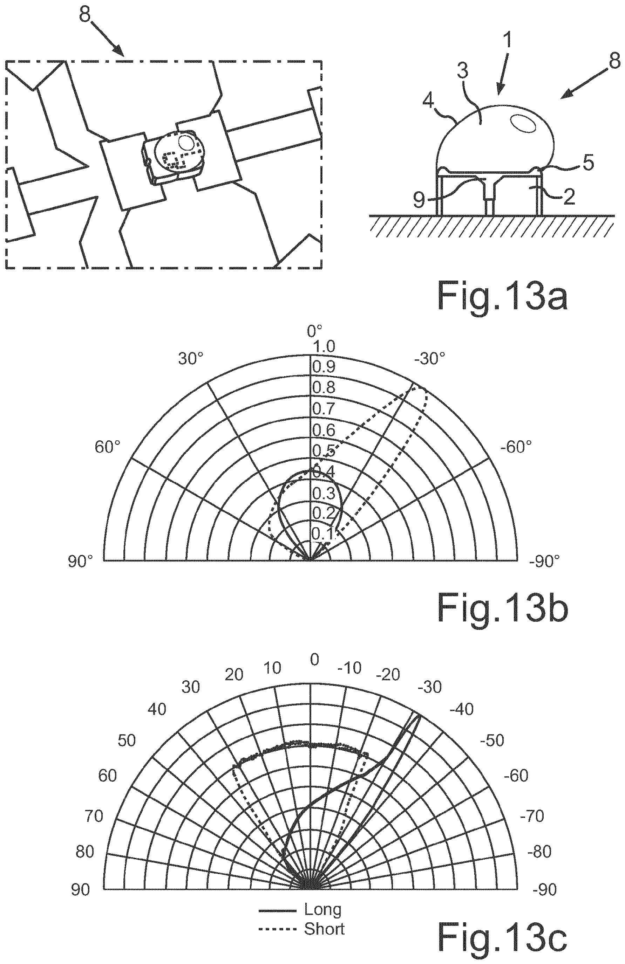

Im Weiteren zeigt Fig. 13 in der Ansicht a) eine mithilfe des erfindungsgemäßen Verfahrens hergestellte CoB-LED der Firma EPIGAP Optronic GmbH mit asymmetrische Polymerlinse 1, wobei die spezielle Linsenform durch Kippen auf bevorzugte Weise mit einem Kippwinkel von 30 bis 60° des im Substrat 2 ausgebildeten CoB-Gehäuses gemeinsam mit dem aufgebrachten polymerhaltigen Medium 3, das aus hochtransparenten und temperaturstabilen Polyurethan der Firma resintec GmbH besteht, während des Austrocknens oder Aushärtens erzeugt wurde.
Die Oberseite der Substratoberfläche 5 wurde, der für die Aufbringung des polymerhaltigen Mediums 3 vorgesehen ist, noch vor der Aufbringung des Mediums mit PTFE beschichtet und die Aushärtung erfolgte bei einem bevorzugten Kippwinkel 30 bis 60° gegenüber der Lotrechten. Ergänzend hierzu zeigt Fig. 13 b) die Simulation der asymmetrischen Lichtstrahlen und Fig. 13 c) das dazugehörige Messergebnis der Lichtverteilung.

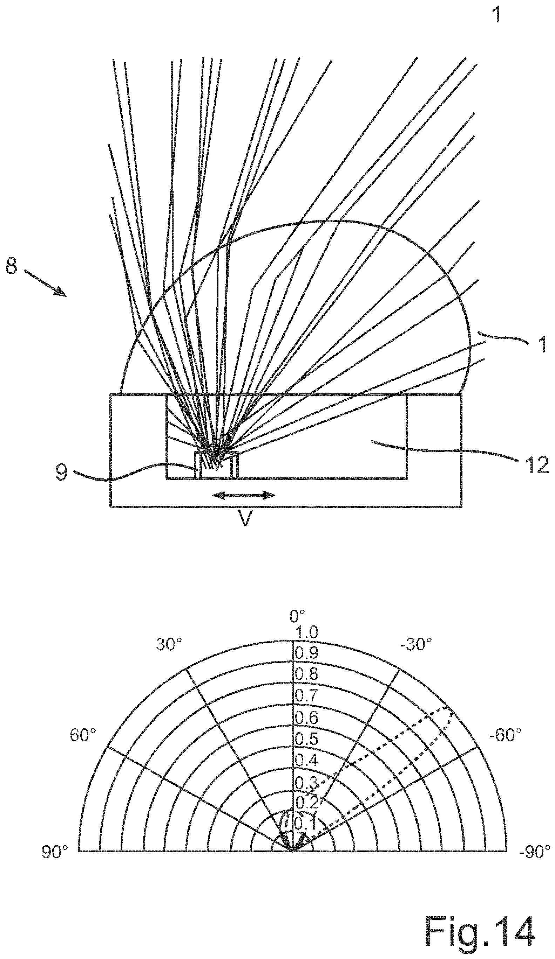

Abschließend ist in Fig. 14 eine spezielle Ausgestaltung einer Leuchteinheit 8 dargestellt, die über eine erfindungsgemäß hergestellte asymmetrische Linse 1 verfügt. Wesentlich an der gezeigten technischen Lösung ist, dass die als Lichtquelle 9 verwendete LED innerhalb eines in einem Substrat 2 ausgebildeten Hohlraums 12, der ein Gehäuse für die LED bildet, außermittig, also mit einem Versatz V zum Mittelpunkt angeordnet ist. Mit Hilfe einer derartigen Anordnung einer LED in Kombination mit einer symmetrischen Linse wird bei bekannten Leuchteinheiten 8 eine asymmetrische Ausleuchtung realisiert. Nachteilig an einer derartigen Anordnung der LED ist jedoch, dass durch Abschattungen teilweise erhebliche Effizienzverluste hingenommen werden müssen. Wird, wie in Fig. 14 gezeigt, eine außermittig angeordnete LED als Lichtquelle 9 mit einer erfindungsgemäß hergestellten asymmetrischen Linse 1 kombiniert, können vergleichsweise effektive Weitwinkellichtverteilungen erzielt werden. Denkbar ist es in diesem Zusammenhang, die Effektivität durch Einsatz wenigstens eines Reflektors weiter zu verbessern.

### Bezugszeichenliste

- 1: Linse
- 2: Substrat
- 3: Medium
- 4: Formkörper
- 5: Substratoberfläche
- 6: Kippwinkel
- 7: Formkörperaußenfläche
- 8: Leuchteinheit
- 9: Lichtquelle
- 10: Drehscheibe
- 11: Mikrostruktur
- 12: Hohlraum

- V: Versatz

## Patentansprüche

1. Verfahren zur Herstellung asymmetrischer oder asphärischer Linsen (1), bei dem wenigstens ein polymerhaltiges Medium (3) in einem für einen Durchtritt oder eine Emission von Strahlung vorgesehenen Bereich eines Substrats (2) auf das Substrat (2) unter Bildung eines Formkörpers (4) aufgebracht wird und das polymerhaltige Medium zumindest zeitweise getrocknet und/oder gehärtet wird,
**dadurch gekennzeichnet, dass** das Substrat (2) bevor, während und/oder nachdem das noch nicht vollständig getrocknete oder ausgehärtete Medium (3) auf das Substrat (2) aufgebracht wird, derart in eine Formgebungsposition bewegt wird, dass hierdurch wenigstens zeitweise eine Formgebungskraft in das auf das Substrat (2) aufgebrachte Medium (3) eingeleitet wird, deren Wirkrichtung von der Richtung der Erdbeschleunigung abweicht.

2. Verfahren nach Anspruch 1,
**dadurch gekennzeichnet, dass** eine Oberfläche (5) des Substrats (2), auf der das zumindest noch nicht vollständig getrocknete oder ausgehärtete Medium (3) angeordnet ist zumindest zeitweise während oder nach der Aufbringung des Mediums (3) derart relativ zu einer durch das Substrat (2) verlaufenden Lotrechten geneigt wird, dass die Oberfläche (5) des Substrats (2) mit der Lotrechten einen von 90° abweichenden Kippwinkel (6) einschließt.

3. Verfahren nach Anspruch 1 oder 2,
**dadurch gekennzeichnet, dass** der Kippwinkel (6) in Abhängigkeit der gewünschten Abstrahlcharakteristik der Linse (1) eingestellt wird.

4. Verfahren nach einem der vorangehenden Ansprüche,
**dadurch gekennzeichnet, dass** in wenigstens zwei Bereichen des Substrates (2) Medium (3), das gleiche oder unterschiedliche Eigenschaften aufweist, unter Ausbildung von Formkörpern (4) auf das Substrat (2) aufgebracht wird und die wenigstens zwei jeweils vom Medium (3) gebildeten Formkörper (4) gemeinsam mit dem Substrat (2) in die Formgebungsposition bewegt werden.

5. Verfahren nach Anspruch 4,
**dadurch gekennzeichnet, dass** in wenigstens zwei Bereichen des Substrates (2) Medium (3) derart auf das Substrat (2) aufgebracht wird, dass Außenflächen (7) der wenigstens zwei jeweils vom Medium gebildeten Formkörper (4) beabstandet zueinander angeordnet sind.

6. Verfahren nach einem der vorangehenden Ansprüche,
**dadurch gekennzeichnet, dass** das Substrat (2) mit dem darauf angeordneten, zumindest noch nicht vollständig getrockneten oder ausgehärteten Medium (3) zumindest zeitweise während oder nach der Aufbringung des Mediums (3) in eine Drehbewegung versetzt wird.

7. Verfahren nach Anspruch 6,
**dadurch gekennzeichnet, dass** eine Drehgeschwindigkeit der Drehbewegung verändert wird.

8. Verfahren nach Anspruch 6 oder 7,
**dadurch gekennzeichnet, dass** eine Lage eines Drehpunkts, um den die Drehbewegung erfolgt, verändert wird.

9. Verfahren nach einem der vorangehenden Ansprüche,
**dadurch gekennzeichnet, dass** eine Art und/oder Geschwindigkeit der Bewegung in die Formgebungsposition und/oder eine zumindest zeitweise erfolgende Veränderung der Art und/oder Geschwindigkeit der Bewegung in die Formgebungsposition in Abhängigkeit der gewünschten Abstrahlcharakteristik der Linse (1) vorgenommen wird.

10. Verfahren nach einem der Ansprüche 6 bis 9,
**dadurch gekennzeichnet, dass** in wenigstens zwei Bereichen eines Substrates (2) ein Medium jeweils unter Ausbildung von Formkörpern (4) auf das Substrat aufgebracht und derart angeordnet wird, dass Schwerpunkte der jeweils von einem Medium (3) gebildeten Formkörper (4) unterschiedlich weit von einem Drehpunkt, um den die Drehbewegung erfolgt, entfernt sind.

11. Verfahren nach einem der vorangehenden Ansprüche,
**dadurch gekennzeichnet, dass** das Medium (3) zur Aushärtung und/oder Trocknung während oder nach der Bewegung des Substrats (2) in die Formgebungsposition zumindest zeitweise mit elektromagnetischer Strahlung mit einer Wellenlänge, die kleiner als 380 nm ist, bestrahlt wird.

12. Verfahren nach einem der vorangehenden Ansprüche,
**dadurch gekennzeichnet, dass** das Medium (3) vor Einleitung der Bewegung in die Formgebungsposition durch einen Schmelzvorgang aus einem festen Zustand in einen fließfähigen Zustand überführt wird.

13. Verfahren nach einem der vorangehenden Ansprüche,
**dadurch gekennzeichnet, dass** der Bereich des Substrats (2), auf den das Medium (3) aufgebracht wird, vor Aufbringung des Mediums (3) teilweise oder ganzflächig oberflächenbehandelt wird.

14. Sensor mit wenigstens einer Linse (1), die mit einem Verfahren nach einem der vorangehenden Ansprüche hergestellt ist.

15. Leuchteinheit (8) mit einer Lichtquelle (9), die wenigstens bereichsweise von einer nach einem Verfahren gemäß der Ansprüche 1 bis 13 hergestellten asymmetrischen oder asphärischen Linse (1) überdeckt ist.

16. Leuchteinheit nach Anspruch 15,
**dadurch gekennzeichnet, dass** die Lichtquelle (9) eine LED, eine Chipintegrierte Strahlungsquelle und/oder ein Lichtwellenleiterende aufweist.

17. Leuchteinheit nach Anspruch 15 oder 16,
**dadurch gekennzeichnet, dass** wenigstens zwei Lichtquellen (9) vorgesehen und derart ausgeführt sowie angeordnet sind, dass das von den Lichtquellen (9) in Strahlrichtung nachgeschalteten asymmetrischen oder asphärischen Linsen (1) ausgesendete Licht in zumindest einem Bereich gemischt wird.
